# FASCICULE DE BREVET EUROPEEN

(11) **EP 1 992 018 B1**
(45) Date de publication et mention de la délivrance du brevet: **28.12.2016**
(21) Numéro de dépôt: 07713054.0
(22) Date de dépôt: 22.02.2007
(51) Int. Cl.: H01L 31/18, H01L 31/05

(54) **PROCEDE DE COUPLAGE DE CELLULES PHOTOVOLTAIQUES ET FILM PERMETTANT SA MISE EN OEUVRE**
VERFAHREN ZUM KOPPELN VON FOTOVOLTAISCHEN ZELLEN UND FILM ZU SEINER IMPLEMENTIERUNG
METHOD OF COUPLING PHOTOVOLTAIC CELLS AND FILM FOR IMPLEMENTING IT

(30) Priorité: 22.02.2006 WO PCT/IB2006/000367
(43) Date de publication de la demande: 19.11.2008
(73) Titulaire: Ses Societe d'Energie Solaire SA, 1228 Plan Les Ouates (CH)
(72) Inventeur: HADORN, Jean-Christophe, CH-1035 Bournens (CH); OUZILOU, Olivier, CH-1844 Villeneuve (CH); CRISAFULLI, Sandrine, CH-1204 Genève (CH); LEU, Sylvère, CH-8824 Schönenberg (CH)
(74) Mandataire: Long, Giorgio
(86) Numéro de dépôt international: PCT/IB2007/000428
(87) Numéro de publication internationale: WO 2007/096752

(56) Documents cités:
- GB-A- 1 469 685
- US-A- 4 173 820
- US-A- 4 739 919
- DUPONT: 'Summary of Properties for Kapton® Polyimide Films - DuPont', [en ligne] 01 Janvier 2015, Extrait de l'Internet: <URL:http://www.dupont.com/content/dam/asse ts/products-and-services/membranes-films/as sets/DEC-Kapton-summary-of-properties.pdf> [extrait le 2015-02-23]

## Description

La présente invention est relative au domaine des cellules photovoltaïques, plus particulièrement à un procédé de couplage électrique des cellules qui s'intègre dans le procédé de fabrication de panneaux solaires et qui permet d'automatiser ledit procédé de fabrication. Le procédé objet de l'invention utilise un film souple pour réaliser les connexions des cellules entre elles et permet ainsi d'augmenter la cadence de fabrication des panneaux solaires, d'offrir une bien meilleure qualité des soudures réalisées tout en respectant l'environnement. L'invention a également pour objet des panneaux solaires directement obtenus par le procédé de fabrication objet de l'invention ainsi qu'un film souple permettant la mise en oeuvre du procédé de connexion des cellules entre elles. Un autre objet de l'invention est relatif à l'utilisation dudit film souple pour réaliser la connectique périphérique des panneaux solaires réalisés selon des procédés traditionnels.

Les modules photovoltaïques permettent d'élever le courant bas et la tension basse des cellules photovoltaïques isolées au moyen d'un couplage en parallèle et en série desdites cellules afin d'obtenir une tension de service utilisable.

L'état de la technique comprend un procédé de couplage en série, ou en série et en parallèle, des cellules photovoltaïques consistant à souder des bandes de connexion entre les pôles positifs, généralement situés sur la face arrière de la cellule, et les pôles négatifs, généralement situés sur la face avant de ladite cellule afin de coupler électriquement deux cellules adjacentes.

Le couplage de plusieurs cellules disposées de manière adjacente les unes par rapport aux autres de façon à obtenir une bande généralement de 8 à 12 cellules utilisant ce procédé de soudage est long et délicat.

Il existe des cellules photovoltaïques dont les pôles positifs et négatifs sont exclusivement situés sur la face arrière de la cellule. Pour ces cellules, un autre procédé de couplage électrique de ces cellules photovoltaïques entre elles, faisant également partie de l'état de la technique, consiste à réaliser la connectique soit par des pattes ou par des éléments appelés osselets qui sont constitués d'un alliage métallique. Ce procédé est délicat, souvent manuel, donc lent et peut endommager des cellules d'épaisseur mince.

US 4,133,697 divulgue un dispositif comportant un circuit imprimé sur lequel sont soudées des cellules photovoltaïques. Le dispositif permet une certaine automatisation du procédé de soudage. Le désavantage de ce procédé provient essentiellement du fait que les soudures doivent être effectuées sur les faces avant et arrière du circuit imprimé ce qui rend l'opération plus délicate. Ces soudures sont réalisées par une lampe à infrarouge ce qui ne permet pas d'assurer une qualité optimale des soudures et présente un risque d'endommager les cellules photovoltaïques.

US 4173820 divulgue les panneaux solaires et un procédé de formation d'une bande de matrice solaire flexible adapté pour être stocké dans un rouleau enroulé en hélice.

Le but de la présente invention est de proposer un film support souple adapté à un procédé de couplage de cellules photovoltaïques, ledit film permettant de simplifier l'automatisation du couplage électrique desdites cellules. L'utilisation de ce film souple permet la réalisation du couplage électrique des cellules par la mise en oeuvre d'un procédé de soudage à la vague qui améliore de façon significative la productivité et diminue le temps de fabrication de modules photovoltaïques tout en offrant une plus grande fiabilité de la connectique.

Un autre but de l'invention est de réaliser la connexion électrique des cellules entre elles et vers l'extérieur sans avoir recours à une soudure au plomb telle qu'elle est utilisée à ce jour dans l'industrie photovoltaïques. Les panneaux solaires obtenus par le procédé selon l'invention sont exempts de plomb ce qui facilite leur recyclage et diminue les coûts de fabrication.

Conformément à l'invention, ce but est atteint grâce à un procédé de couplage des cellules selon la revendication 1.

Le film support souple comporte un macro circuit imprimé sur l'une de ces faces et accueille les cellules photovoltaïques sur l'autre de ces faces. Le film support comporte une pluralité de trous traversants agencés de manière à ce qu'ils coïncident avec des points de connexion, situés sur la face arrière desdites cellules, afin de permettre un brasage automatisé à la mini vague sélective assurant le couplage électrique des cellules photovoltaïques par l'intermédiaire du macro circuit imprimé.

D'autres caractéristiques de l'invention sont exposées dans les revendications et ressortiront dans la description qui suit.

Un mode d'exécution principal de l'invention va maintenant être décrit à titre d'exemple, nullement limitatif en se référant aux figures schématiques annexées, dans lesquelles :
- La figure 1 représente une vue éclatée en perspective d'un module photovoltaïque constitué de cellules à contacts en face arrière, du film support, de films d'encapsulation et de films protecteurs.
- La figure 2 représente une vue de dessus du film support comportant des trous métallisés correspondant aux points réalisés par brasage.
- La figure 3 représente une vue de dessus du film support sur lequel sont agencées les cellules photovoltaïques.
- La figure 4 représente une vue de dessous du film support comportant le macro circuit imprimé, ledit film étant représenté en transparence de manière à pouvoir visualiser les cellules photovoltaïques.
- La figure 5 représente une vue de dessous d'une cellule photovoltaïque avec les points de connexion.
- La figure 6 représente une vue en coupe partielle d'une brasure.
- La figure 7 représente une vue du côté opposé aux cellules de quatre films support assemblés entre eux destinés à recevoir 72 cellules photovoltaïques pour constituer un module.
- La figure 8 illustre deux cellules à contacts avant et arrière connectées en série.
- La figure 9 représente schématiquement un module composé de cellules telles qu'illustrées à la figure 8 et obtenu par un procédé traditionnel, sur lequel la connectique périphérique a été réalisée.
- La figure 10 représente un module composé de cellules à contacts arrière, obtenu par un procédé traditionnel et illustrant également la connectique périphérique.
- La figure 11 est un agrandissement partiel de la figure 10.
- La figure 12 illustre un module composé de cellules à contacts arrière fabriqué par un procédé traditionnel pour connecter les cellules entre elles et sur lequel la connectique périphérique est réalisée par l'intermédiaire d'un film souple muni d'un circuit imprimé.
- La figure 13 représente une vue de dessus respectivement de dessous de cellules terminales à contacts avant et arrière.
- La figure 14 représente un module à cellules à contacts avant et arrière sur lequel la connectique périphérique est réalisée par l'utilisation de deux bandes d'un film souple muni d'un circuit imprimé.
- La figure 15 est une vue d'une boîte de jonction destinée à équiper le dos des panneaux solaires.
- La figure 16 illustre schématiquement le dos d'un panneau solaire sur lequel est connectée une boîte de jonction.

L'industrie du photovoltaïque bénéficie aujourd'hui d'une dérogation par rapport aux normes européennes de soudure/brasure sans plomb RoHs car les procédés actuels ne permettent ni une bonne adhérence de la cellule, ni une bonne tenue à long terme. Le procédé de fabrication objet de l'invention pallie à ce problème et rend le procédé particulièrement attractif lorsque l'on considère les coûts de recyclage des modules. Il n'est en effet plus nécessaire de pratiquer un recyclage onéreux et compliqué pour éliminer le plomb des panneaux solaires fabriqués si l'on a recours au procédé de l'invention. Ce procédé permet également de supprimer une étape complète lors de la fabrication industrielle de modules photovoltaïques. Toute la connectique périphérique peut désormais être réalisée en une seule étape au dos du film.

Dans les procédés connus, les rubans assurant la connectique périphérique des cellules doivent être isolés afin d'éviter des arcs électriques et afin également de permettre le raccord vers la boîte de jonction située au dos des modules. Les étapes nécessaires à la connexion périphérique traditionnelle et son isolation sont éliminées ce qui représente un gain de temps et de fiabilité significatif. On notera également que l'étape du procédé de fabrication relative à la connectique périphérique par film peut s'appliquer aussi bien à des cellules à contacts arrière qu'à des cellules présentant des contacts avant et arrière.

Une technique de soudure utilisée dans d'autres domaines est celle connue sous le nom de brasure à la vague dont le principe est de souder à l'aide d'une vague passant à travers un trou métallisé. Cette méthode est rapide, se prête bien à l'automatisation et donne de bons résultats. Cette technique est utilisée en particulier pour la fabrication de circuits intégrés mais n'a toutefois jamais pu être utilisée dans la fabrication de panneaux solaires principalement à cause du fait que les températures des bains de soudure sont trop élevées et endommagent les cellules photovoltaïques lors de leur soudage. Ceci est d'autant plus vrai lorsque l'on désire réaliser une brasure sans plomb qui impose une augmentation de la température du bain de 30 à 40 degrés par rapport à une brasure traditionnelle à l'étain/plomb. Lorsque les cellules sont exposées à une température trop élevée, on constate l'apparition de micro fissures et une déformation sur les cellules ce qui diminue considérablement leur durée de vie. Dans les procédés de soudure/brasure sans plomb, le mouillage est également moins bon que celui de la soudure traditionnelle à l'étain/plomb.

Pour résoudre ces problèmes et afin de pouvoir mettre en oeuvre une technique de brasure à la vague sans plomb pour réaliser les connexions des contacts arrières des cellules photovoltaïques entre elles, il a tout d'abord été nécessaire de mettre au point un film souple multicouche présentant les caractéristiques requises pour à la fois résister aux températures élevées des bains de soudure sans plomb et offrir les caractéristiques électriques, mécaniques et de longévité indispensables dans la fabrication des modules de panneaux solaires, tout en pouvant recevoir des pistes conductrices de cuivre.

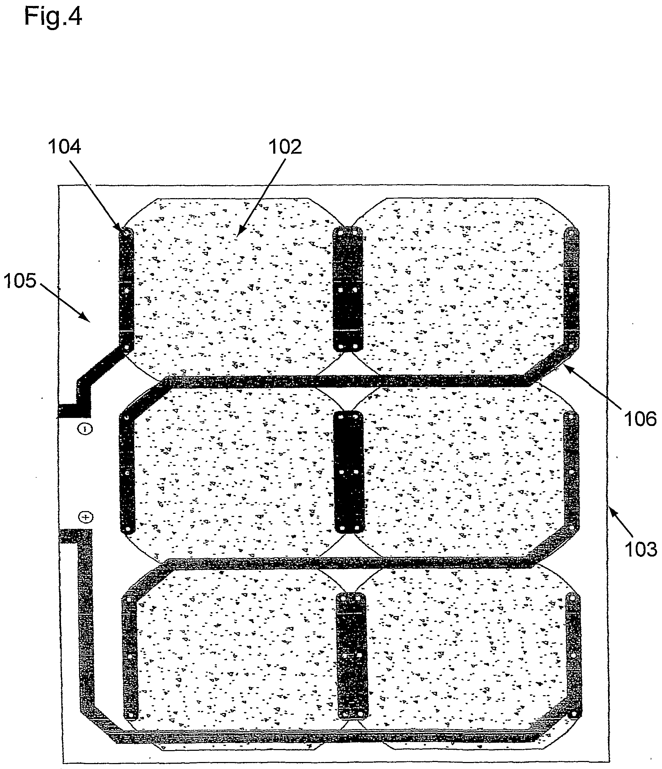

Selon le mode d'exécution illustré à la figure 4, le macro circuit imprimé 105 réalisé sur le film support 103, sur lequel sont fixées par brasage des cellules photovoltaïques 102, assure la connexion électrique entre lesdites cellules 102.

Les cellules photovoltaïques 102 utilisées dans le procédé objet de la présente invention sont des cellules dont les points de connexions se situent exclusivement sur leurs faces arrières.

De préférence, le support souple ou film 103 est réalisé par un accouplement de deux couches de matériaux présentant des propriétés différentes. La couche supérieure de ce film 103 est de préférence en poly-fluorure de Vinyle vendu par exemple sous la marque Tedlar®. Ce matériau présente les caractéristiques suivantes :
- excellente résistance mécanique,
- résistance aux intempéries,
- résistance aux rayons ultra-violets et à l'humidité.

Le Tedlar® présente par ailleurs une excellente stabilité dans le temps, et son utilisation est reconnue par l'industrie photovoltaïque.

La couche inférieure sera de préférence constituée d'un matériau isolant et résistant à des températures élevées telles que celles rencontrées dans les opérations de brasage à la vague. Un matériau tel que le Mylar® par exemple possède des caractéristiques qui le rende avantageux en comparaison d'autres matériaux dans l'optique d'une application industrielle du procédé selon l'invention. Le Mylar® présente les caractéristiques suivantes :
- une excellente résistance chimique, une résistance à l'huile, aux graisses et à l'humidité. Il est particulièrement adapté au procédé de métallisation, d'impression ou d'emboutissage. Cette propriété est un atout majeur pour recevoir des pistes de cuivre par différentes réactions chimiques ou de vaporisation.
- Il résiste aux efforts mécaniques (déchirures) ce qui le rend utilisable dans un procédé continu et rapide en roll to roll.
- Il se combine facilement à d'autres matériaux ce qui permet son accouplement sans difficulté, par exemple par laminage, au Tedlar® ou à un film de cuivre.
- Il résiste particulièrement bien aux fortes températures ce qui autorise son utilisation dans des conditions de températures élevées imposées par les procédés de soudure sans plomb.
- Il est de plus un excellent isolant électrique.
- Il est enfin stable ce qui permet d'envisager son utilisation dans des modules solaires durant une période supérieure à 25 ans.

L'accouplement du Tedlar® avec le Mylar® combine les avantages des deux matériaux. Le Tedlar® sur la face avant exposée au rayonnement solaire offre un film résistant aux rayons ultra-violets et aux intempéries et présente une excellente résistance mécanique. Le Mylar® sur la face arrière permet la réalisation des connexions électriques par un procédé de brasage à la vague sans plomb.

Grâce aux propriétés de ces deux matériaux, on obtient un film souple et de faible épaisseur ce qui permet d'éviter l'apparition de micro fissures dans les cellules.

De nombreux essais ont permis de dimensionner les paramètres optimaux pour la réalisation du film souple 103. A titre d'exemple non limitatif, une couche de Tedlar® dont l'épaisseur est comprise entre 15 et 45 microns, de préférence 25 microns, accouplée à une couche de Mylar® de 75 à 125 microns d'épaisseur, de préférence 100 microns, a donné d'excellents résultats. Le film souple et fin 103 ainsi obtenu peut être utilisé dans le procédé de brasure à la vague décrit plus loin.

Pour réaliser le film souple 103 qui comprend le macro circuit imprimé 105 sur sa face inférieure illustrée à la figure 4 par exemple, on assemble une couche de Tedlar® et une couche de Mylar® comme expliqué ci dessus, ces deux couches sont ensuite prises en sandwich entre deux couches de cuivre d'une épaisseur d'environ 35 microns puis les quatre couches sont solidarisées par laminage par exemple. Un procédé classique est ensuite utilisé pour réaliser le circuit imprimé 105 situé sur la couche de Mylar® en enlevant les portions de cuivre qui ne font pas partie du circuit à réaliser. La couche de cuivre supérieure ne sert en pratique qu'à permettre la métallisation des trous de connexion 104, ainsi que pour faire apparaître des pastilles au niveau du point de soudure afin de concentrer la chaleur et éviter que l'étain du bain de brasage ne s'écoule sous la cellule. De préférence, les pastilles au niveau du point de soudure comprendront des freins thermiques qui favorisent la concentration de chaleur sur le point de soudure et évitent la dissipation de chaleur vers les cellules et la bande de cuivre. La couche de cuivre supérieure résiduelle est ensuite éliminée pour laisser apparaître le Tedlar® sur la face avant du film.

Des orifices peuvent être pratiqués dans les couches du film 103 ne recevant pas les pistes de cuivre pour permettre une meilleure circulation de l'encapsulant lors de l'étape de laminage.

Le macro circuit imprimé 105 est quant à lui réalisé par élimination d'une partie du cuivre recouvrant le Mylar® pour former les pistes de connexion permettant l'interconnexion des cellules entre elles ainsi que les connexions périphériques pour relier la boîte de jonction 116 généralement située sur la face arrière des modules solaires (fig. 19).

Il est évident que d'autres matériaux présentant les caractéristiques essentielles mentionnées ci-dessus pourraient être utilisés pour former le film souple 103. Actuellement, le couplage Tedlar®/Mylar® présente le rapport qualité/prix le plus favorable à une industrialisation.

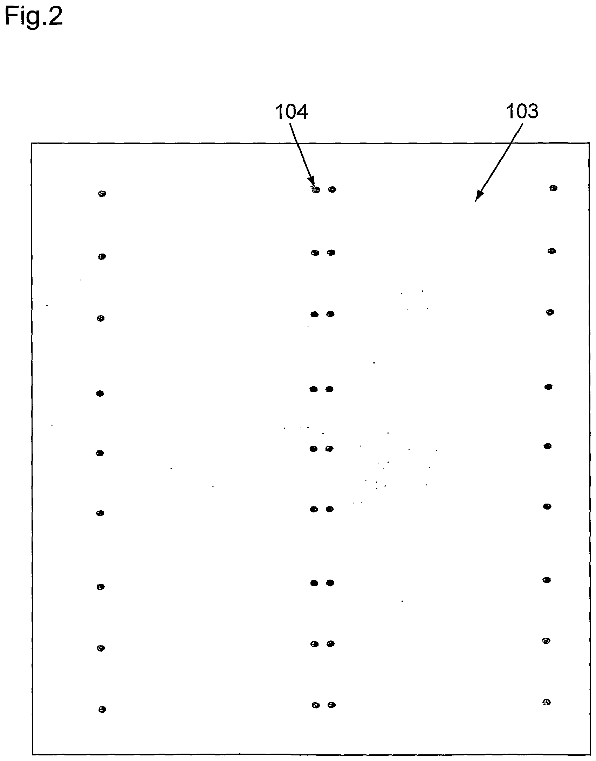

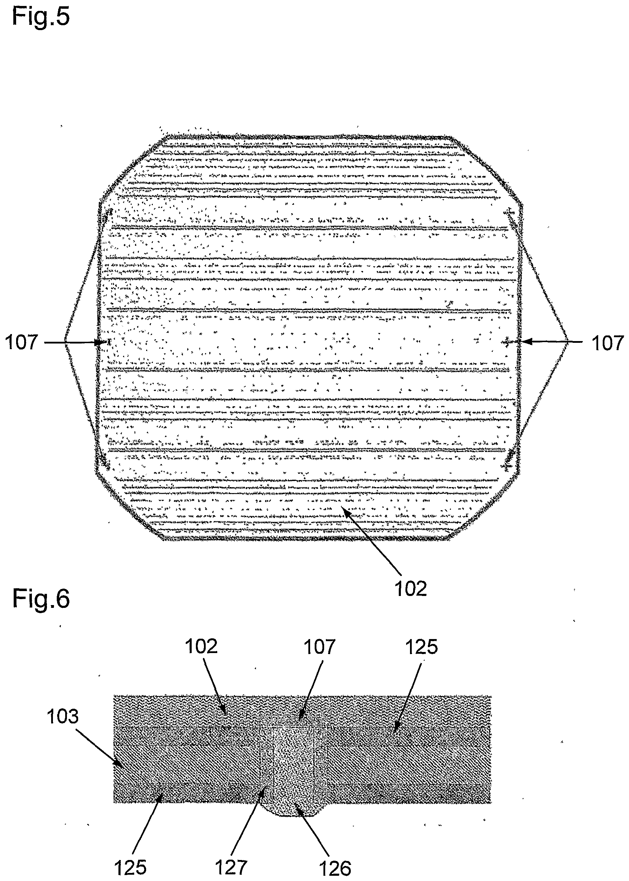

Les cellules photovoltaïques 102 sont disposées sur la face avant du film support 103 opposée à la face comportant le macro circuit imprimé 105. Cette face avant comporte plusieurs trous métallisés 104 telle qu'illustrée par la Figure 2. Ces trous 104 sont agencés de manière à ce qu'ils coïncident avec les points de connexion 107 (Figure 5) desdites cellules 102.

Les points de connexion 107 des cellules photovoltaïques 102 sont actuellement situés de préférence en alignement de trois de manière équidistante de part et d'autre de ladite cellule 102 (Figure 5), mais peuvent être de nombre et d'emplacement quelconque dans le présent procédé.

Les trous 104 sont agencés sur le film support 103 afin de coïncider avec ces points 107 lorsque les cellules 102 sont positionnées sur ledit film 103. Ces trous 104 sont métallisés favorisant le brasage par capillarité du métal d'apport 126.

La face arrière du film 103 telle qu'illustrée par la Figure 4 comporte ledit circuit imprimé 105 constitué de pistes 106 de cuivre réalisées par un procédé d'impression de circuits, les pistes 106 étant optimisées selon chaque type de cellules et leur nombre de manière à connecter les cellules 102 en série. Ces pistes 106, qui sont généralement en cuivre étamé, sont dimensionnées pour supporter les tensions en marche normale et de claquage des cellules photovoltaïques 102. La totalité des trous 104 sont recouverts par ou reliés aux dites pistes 106 de manière à pouvoir réaliser le couplage électrique de la totalité des cellules 102 agencées sur la face avant du film support 103.

Pour éviter les projections de matière lors de l'opération de brasure à la vague, les parties des pistes 106 ne coïncidant pas avec un trou 104 seront de préférence recouvertes d'un film protecteur.

Le circuit imprimé est généralement conçu de manière à pouvoir recevoir un tableau constitué de deux à n X 2 cellules et assurer l'interconnexion de celles-ci.

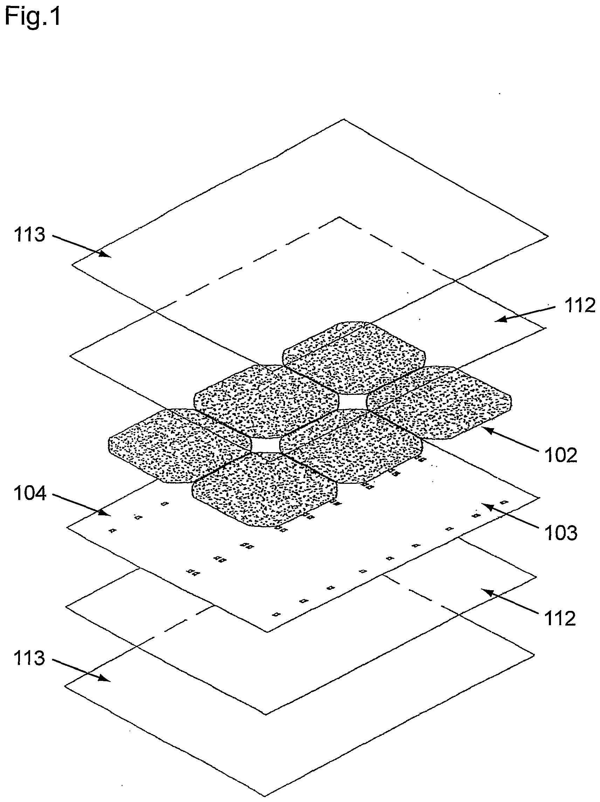

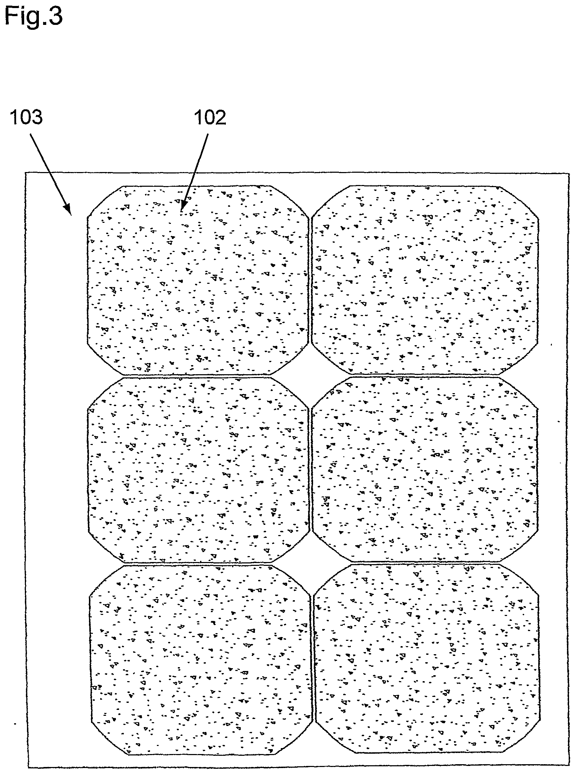

L'interconnexion électrique desdites cellules 102 permet de produire des modules de différentes tailles. Ceux-ci sont généralement composés desdites cellules encapsulées entre deux plaques de verre ou entre une plaque de verre et un film plastique. En règle générale, les modules utilisés comme tuile solaire sont constitués de 6 cellules photovoltaïques (Figure 1, 3 et 4) alors qu'un module ou panneau solaire courant est constitué par exemple de 72 cellules.

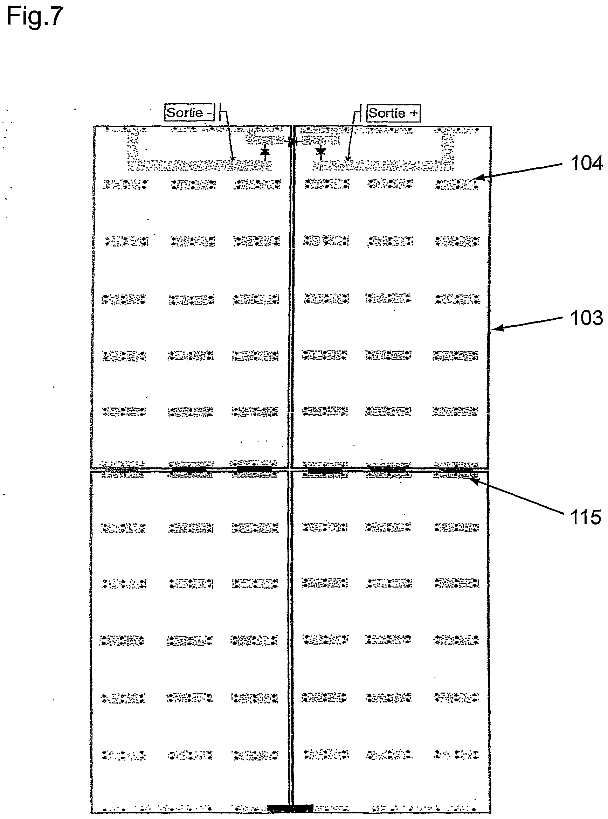

Pour ce type de module, un seul film support 103 peut être réalisé sur le même principe. Cependant, avec les machines à braser existantes, il faut travailler en 4 quarts. Les 4 films support 103 sont agencés côte à côte tels qu'illustrés par la Figure 7, lesdits films 103 étant rendus solidaires les uns par rapport aux autres par des languettes de liaison 115 soudées aux différents films 103.

Selon le type de modules fabriqués, il est également possible de travailler dans d'autres configurations en fonction du nombre de cellules mises en place. Dans tous les cas le film 103 peut être pré-coupé ou délivré en un seul rouleau.

Le procédé de fabrication des modules solaires objet de la présente invention va maintenant être décrit en détail. Il comporte les étapes suivantes.
- déroulement du film souple 103 en continu ou par l'intermédiaire d'un chariot de convoyage,
- arrêt du film souple 103 au niveau d'un masque de soudage, ledit masque étant ajusté contre la face du film comportant le macro circuit imprimé 105 afin qu'il recouvre la totalité du film support 103 exceptés les trous 104,
- le positionnement des cellules photovoltaïques 102 sur la face dudit film 103 opposée à la face comportant ledit circuit imprimé 105, les points de connexion 107 desdites cellules 102 étant ajustés exactement aux emplacements adéquats en regard des trous 104 métallisés du film 103. De préférence, on utilisera pour le positionnement des cellules un procédé qui permet non seulement de positionner précisemment les cellules sur la face supérieure du film 103 mais également de les maintenir plaquées sur ledit film 103. Les cellules ayant tendance à se déformer sous la chaleur, il est important qu'elles soient plaquées sur le support lors du passage dans la vague. Le système de maintien des cellules contre le support sera de préférence isolé thermiquement de façon à ne pas absorber rapidement la chaleur au moment de la brasure. Les procédés connus de type Bernoulli par exemple sont parfaitement adaptés pour réaliser cette opération,
- brasure à la mini vague sélective des cellules photovoltaïques 102 aux points de connexion 107 sur le film support 103.

Le masque de soudage est une réplique de la face avant du film 103 comportant des trous aux emplacements identiques à ce dernier tel qu'illustré par la Figure 2. Pour éviter d'endommager le film 103 durant la brasure à la mini vague sélective, à cause des températures élevées du bain, le masque de soudage sera de préférence constitué d'une table en aluminium présentant deux parois entre lesquelles on fait circuler un flux d'air soufflé de manière à refroidir le film 103.

La machine à braser à la mini vague sélective réalise la connexion entre les points de connexions 107 des cellules photovoltaïques 102 et les pistes 106 du macro circuit imprimé 105. Les mini vagues sélectives brasent la totalité des trous 104 par capillarité. La connectique de la totalité des cellules photovoltaïques 102 ainsi que les connexions électriques de l'ensemble des cellules 102 avec l'extérieur sont donc réalisées en une seule opération grâce à ce procédé.

Pour augmenter la mouillabilité des trous métallisés 104, et ainsi permettre une meilleure brasure, on peut prévoir une étape de fluxage préalable durant laquelle on expose le film à un flux approprié tel qu'un flux de type CORBAR 936B5 par exemple.

Lors de l'étape de fluxage, seul le film 103 peut être exposé. En effet, la métallisation des points de contact de la cellule présente en général une meilleure mouillabilité que celle du film 103 dont la métallisation des trous est généralement obtenue par galvanisation. Le flux appliqué sur le film permet d'accentuer la mouillabilité des trous métallisés 104 et ainsi d'améliorer la qualité des brasures obtenues. Ce flux s'évapore lors de la soudure et ne réagit pas avec les matériaux environnants.

Des essais ont été effectués sur une machine de brasure à la vague standard RoHS pour réaliser une brasure sans plomb. L'utilisation de cette machine a permis d'obtenir de très bons résultats qui peuvent encore être améliorés par l'utilisation d'une machine à souder à mini vagues sélectives. En effet, les essais ont montré que les critères de température et de flux ne sont pas les plus significatifs, c'est en revanche, en donnant une hauteur de vague maximum que l'on obtient des brasures optimales. La hauteur de la vague favorise la prise de la brasure, l'effet de remontée capillaire du métal d'apport dans le trou métallisé étant moins important que lors de la brasure d'un élément traversant. En ajustant les paramètres des mini vagues sélectives, on peut également envisager de ne pas métalliser les trous 104.

La machine permettant le brasage à la mini vague sélective pour une application photovoltaïque a été développée en parallèle à la mise au point du procédé.

A titre d'exemple non limitatif, un bain d'étain sans plomb de type SAC 305 (Sn 96.5%, Ag 3%, Cu 0,5%) peut être utilisé pour réaliser la brasure à la vague des cellules photovoltaïques 102 sur un film souple 103 constitué d'une couche de Tedlar® accouplée à une couche de Mylar®.

L'opération de brasure à la vague sélective peut également être réalisée dans un environnement azoté, ceci améliore encore la qualité des soudures, notamment en permettant de réaliser des brasures de moindre épaisseur. L'obtention de brasures aussi plates que possible améliore ensuite la qualité des opérations de laminage des modules solaires qui suivent généralement les étapes de soudure des cellules.

La figure 6 représente le détail d'un trou métallisé 104 dont du cuivre étamé 125 a été déposé sur la circonférence interne pour réaliser une métallisation 127. Une brasure est réalisée dans le trou 104 de manière à souder un point de connexion 107 d'une cellule photovoltaïque 102 à une piste 106 du macro circuit 105 inhérent au film 103.

Le soudage a lieu par brasage, le métal d'apport reliant le métal desdits trous 104 et le métal des points de connexion 107 des cellules 102.

Les trous métallisés 104 présentent un diamètre de l'ordre de 2 à 4 millimètres, de préférence 3 millimètres ce qui permet d'obtenir des brasures de bonne qualité avec une précision de l'ordre du dixième de millimètre.

Ce procédé permet d'automatiser la connexion des cellules 102 entre elles. Les cellules une fois interconnectées sont ensuite encapsulées entre deux films 112 de préférence en EVA ou autre équivalent, puis entre deux verres 113 ou entre une couche de verre et une couche de Tedlar®, comme dans les modules photovoltaïques traditionnels.

Mis à part la simplicité de la réalisation et la qualité des connexions entre les cellules photovoltaïques 102, ce procédé de brasage offre d'autres avantages. Contrairement aux méthodes actuelles dites de « tabbing » et « stringing » des cellules entre elles pour former un tableau de cellules reliées électriquement, dans la présente invention l'épaisseur des cellules peut être quelconque grâce au film qui les supporte et les connecte, sans que les brasures ne lâchent, ni que les cellules ne se cassent.

Le procédé de brasure à la mini vague sélective fait appel à un phénomène physique naturel de montée par capillarité de l'élément soudant et constitue le meilleur moyen de souder une cellule photovoltaïque sans exercer de stress mécanique sur cette dernière. Les procédés de soudure par conduction ou par laser concentrent la chaleur sur les rubans ou osselets provoquant l'apparition de micro fissures dans les cellules.

L'utilisation d'un procédé de brasure à la vague ou à la mini vague sélective sans plomb selon l'invention permet d'obtenir de hautes performances et une durée de vie supérieure des joints de soudure et des modules. Les soudures avec plomb actuellement pratiquées dans l'industrie présentent un déplacement de la soudure de quelques microns dans des conditions de température extrêmes et sur la durée, ce qui n'est pas le cas dans le procédé objet de l'invention.

Par ailleurs, grâce à l'automatisation de plusieurs étapes par rapport aux procédés traditionnels, il est possible de réduire sensiblement les coûts de production de tels modules.

Bien que le procédé ait été décrit en relation avec les cellules à contacts arrière existantes, il peut s'appliquer mutatis mutandis à toute cellule photovoltaïque qui présenterait des points de connexions multiples situés à l'arrière des cellules, indépendamment de leur localisation ou de leur distribution.

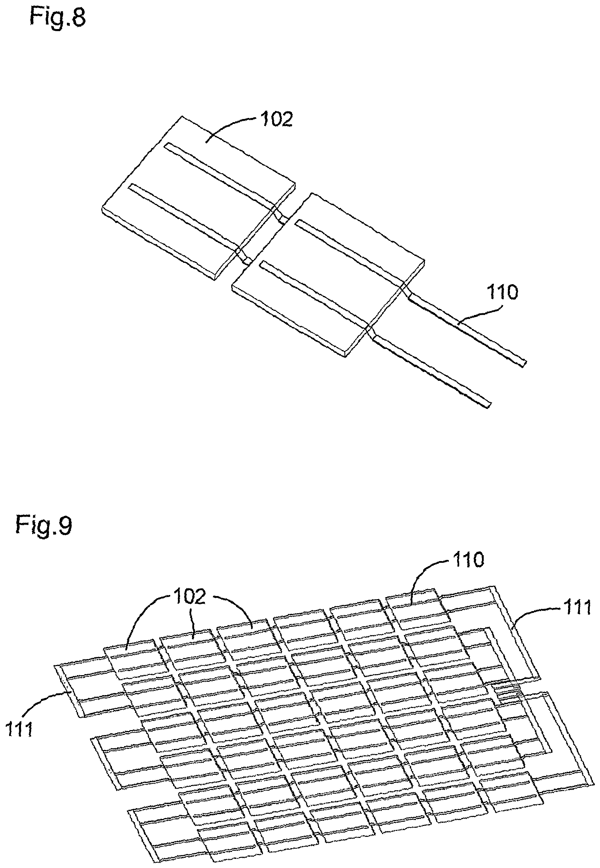

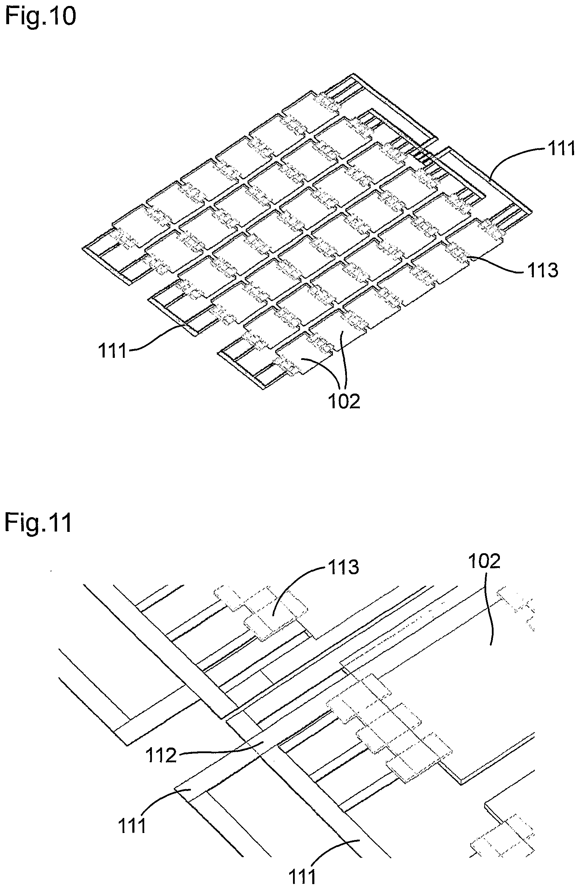

On notera que le film souple 103 décrit dans le procédé ci-dessus peut également être utilisé pour réaliser uniquement la connectique périphérique des modules solaires dont l'interconnexion des cellules entre elles aurait été réalisée par un procédé de fabrication, ceci, aussi bien pour un module constitué de cellules à contacts avant et arrière comme illustré à la figure 9 qu'un module comprenant des cellules à contacts arrière uniquement tel que représenté à la figure 10.

Dans la configuration standard d'un module photovoltaïque, plusieurs cellules sont connectées en série selon un schéma qui diffère d'un constructeur à un autre. L'objectif étant toujours de disposer d'une tension plus élevée et donc d'une puissance du module plus conséquente. Cette connexion est obtenue généralement pour les cellules 102 à contacts avant et arrière à l'aide de rubans 110 soudés sur la surface supérieure et inférieure des cellules solaires 102 comme illustré à la figure 8. Lorsque l'on a réalisé plusieurs bandes de cellules couplées entre elles en série sur le module, il faut connecter ces bandes entre elles : c'est ce que l'on dénomme généralement par connectique périphérique. Elle est généralement réalisée à l'aide de rubans 111 en cuivre étamé ou autres métaux adaptés au type de soudure utilisée. Cette étape est encore souvent réalisée manuellement.

La figure 9 illustre schématiquement à titre d'exemple la connectique générale des cellules entre elles ainsi que la connectique périphérique d'un module composé de 36 cellules traditionnelles à contacts avant et arrière.

La problématique est d'ailleurs identique dans le cas de modules comprenant des cellules à contacts arrière uniquement fabriqués selon les procédés d'assemblage différents de celui décrit ci-dessus. A titre d'exemple, la figure 10 illustre un module solaire comprenant des cellules photovoltaïques 102 à contacts arrière uniquement. La connexion des cellules entre elles est réalisée grâce à des osselets 113 qui relient électriquement en série deux cellules adjacentes.

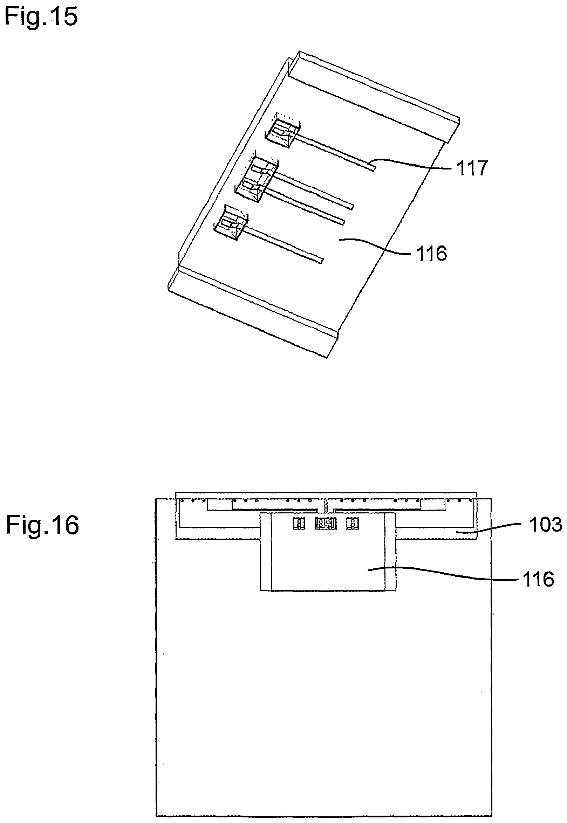

Pour réaliser la connectique périphérique de ce type de module, on soude des rubans 111 aux cellules 102. Ces rubans sont ensuite connectés à une boite de jonction 116 (figures 15 et 16) qui se trouve au dos des modules. Cette boîte de jonction 116 comporte des diodes antiparallèles afin de laisser passer le courant lorsqu'une partie du module est à l'ombre.

Pour réaliser la connectique périphérique du module vers la boite de jonction, il est non seulement nécessaire d'isoler les rubans 111 entre eux lorsqu'ils se superposent, comme par exemple au point 112 de la figure 11, mais également d'isoler les rubans 111 de l'arrière des cellules 102. Cette isolation est généralement effectuée par l'adjonction d'une couche additionnelle de Tedlar® sur chaque zone concernée et nécessite soit une automatisation complexe, soit une main d'oeuvre qualifiée augmentant de ce fait les coûts et/ou les temps de fabrication des modules.

L'utilisation d'une bande de film souple 103 comprenant sur l'une de ses faces un circuit imprimé 105 aux deux extrémités du module permet de réaliser la connectique périphérique en une seule étape en lieu et place des trois étapes précédemment requises (soudage des rubans/ isolation des rubans entre eux / isolation des rubans avec le dos des cellules).

L'utilisation d'un film souple 103 améliore considérablement l'automatisation du procédé de fabrication et rend le produit résultant beaucoup plus fiable. On élimine en particulier le risque d'une isolation défaillante qui pourrait provoquer un court-circuit et un incendie.

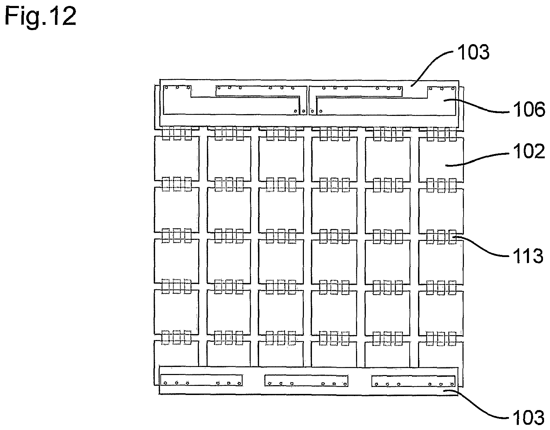

Le film 103 permet la réalisation d'une connectique périphérique sur mesure aussi bien pour les modules comprenant des cellules à contacts arrière (figure 12) que pour les modules réalisés à partir de cellules à contacts avant et arrière (figure 10).

La figure 12 illustre schématiquement un module comportant des cellules 102 à contacts arrière qui sont connectées en série entre elles au moyen d'un procédé traditionnel utilisant des osselets 113. La connectique périphérique du module est réalisée par l'intermédiaire des pistes en cuivre 106 d'une bande de film 103 telle que décrite précédemment, agencées à chacune des extrémités du module.

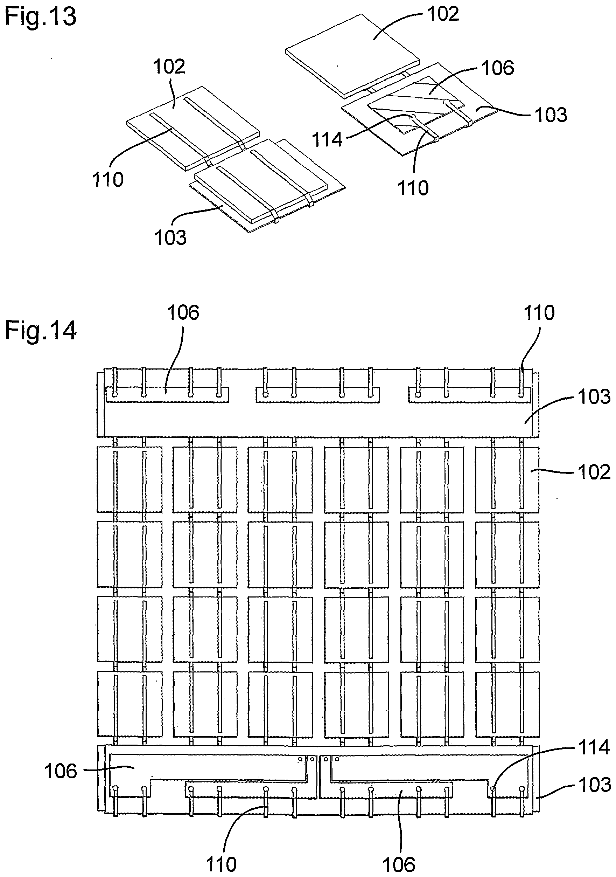

La figure 13 illustre sur sa partie gauche la face avant de deux cellules 102 à contacts avant et arrière situées aux extrémités du module illustré à figure 14. La partie droite de la figure 14 illustre la face arrière de ces mêmes cellules connectées en série à l'aide des rubans 110.

Au lieu de pratiquer des trous dans le film 103, ce qui nécessiterait de passer l'extrémité des rubans 110 à l'intérieur de ces trous, on plie simplement les rubans 110 au niveau de la dernière cellule, comme dans une étape traditionnelle de « tabbing / stringing ». Les rubans 110 sont ensuite soudés directement sur les pistes en cuivre 106 du circuit imprimé situé au dos du film 103.

Cette méthode ne nécessite aucun équipement supplémentaire, il suffit pour effectuer cette opération de modifier les coordonnées des points de soudure pour réaliser les connexions aux points de contact 114 dans les chaînes de fabrication existantes.

La figure 14 illustre une vue arrière d'un module solaire composé de cellules 102 à contacts avant et arrière reliées entre elles en série par des rubans 110. Toute la connectique périphérique est réalisée par deux bandes de film souple 103 à chacune des extrémités du module.

Les avantages que présente cette solution sont nombreux et l'on peut citer à titre non exhaustif les points suivants :
- sûreté de la connectique périphérique, l'isolation complète est réalisée par le circuit imprimé 105.
- automatisation : les mêmes outils de soudure que ceux utilisés actuellement dans les chaînes de fabrication existantes peuvent être utilisés sans modification.
- mise en place facilitée de la boîte de jonction.
- la connectique périphérique est effectuée en une seule étape, les étapes d'isolation ne sont plus nécessaires.
- gain de puissance au mètre carré.

Dans certains modules commercialisés actuellement plusieurs rubans doivent être disposés les uns au-dessus des autres pour respecter l'architecture électrique du module. Cet empilage de rubans augmente la surface totale du module. Grâce au film selon l'invention, les pistes de cuivre 106 remplaçant les rubans 111 sont disposées sous les cellules 102 et permettent ainsi de réduire la surface totale du module.

Les normes en vigueur imposent en effet qu'une certaine distance, actuellement 16 mm, soit laissée libre entre le dernier élément électrique réalisant la connectique périphérique et le bord du module, pour éviter les fuites de courant.

Dans les procédés traditionnels, les points de soudure doivent être réalisés à plusieurs millimètres du bord de la cellule. Grâce à l'utilisation du film 103, les points de soudure sont situés sous les cellules 102 et de ce fait la zone qui doit rester libre de tout composant électrique se calcule non plus par rapport aux rubans mais par rapport au bord de la cellule. Cette solution permet de réduire de manière significative la quantité de matériau (verre, Tedlar®, encapsulant, cadre en aluminium ...) nécessaire pour fabriquer chacune des couches constitutives du module.

Un autre avantage significatif de l'utilisation de ce film pour réaliser la connectique périphérique est relatif à la conception et à la mise en place de la boîte de jonction qui équipe le dos des modules. Cette boîte de jonction est habituellement mise en place après laminage du module.

Dans les procédés traditionnels, il est nécessaire, avant laminage, de faire passer les rubans 111 au travers de l'encapsulant et du Tedlar® puis de les fixer provisoirement à l'aide d'un adhésif sur le dos du module pour permettre le laminage. Après le laminage il faut désolidariser les rubans du module, puis plier ces rubans pour les placer au contact des bornes de la boîte de jonction afin de les souder. Cette étape difficilement automatisable contraint de nombreux industriels à effectuer cette opération manuellement.

L'utilisation du film permet une simplification de cette étape de fabrication. En effet, les pistes de cuivre 106 du film 103 peuvent suivre un chemin les amenant directement au niveau de la boîte de jonction 116 comme cela ressort de la figure 16.

Avant laminage du module, on pratique une découpe dans les couches « encapsulant/Tedlar® », et après laminage, on pose la boîte de jonction au niveau des terminaisons des pistes de cuivre découvertes puis on soude les pistes 117 de la boîte de jonction 116 sur les points de contact situés au dos du module. On notera également que grâce à ce procédé pour réaliser la connectique externe des modules, il est possible de simplifier et de diminuer le coût de fabrication des boîtes de jonction 116. Les boîtes actuellement utilisées doivent en effet être ouvertes au moment de leur fixation au dos du module pour relier les rubans aux pattes de connexion de la boîte. Une fois la soudure de la boîte effectuée, ces dernières doivent être isolées par exemple en les remplissant de silicone. Grâce au procédé décrit ci dessus, les boîtes de jonction peuvent être réalisées en usine, tous les composants électroniques étant disposés dans une enceinte hermétique isolée thermiquement et électriquement. Seule l'extrémité des pistes 117 de la boîte émerge du boîtier scellé de sorte que l'on obtient une mise en place plus aisée de la boîte de jonction mais également plus sûre car la partie active de la boîte de jonction comprenant les composants électroniques n'a plus à être ouverte lors de sa mise en place.

## Revendications

1. Procédé permettant de réaliser le couplage électrique de cellules photovoltaïques (102) entre elles ainsi que la connexion périphérique des cellules (102) vers une boîte de jonction (116), **caractérisé en ce qu'**il comporte les étapes suivantes :
- acheminement d'un film support souple (103) en continu ou par l'intermédiaire d'un chariot de convoyage, ledit film support (103) étant obtenu par accouplement d'une feuille de matière présentant des propriétés de résistance aux rayons ultra-violets et d'une feuille d'un matériau isolant électriquement et résistant aux températures élevées, ledit film comportant sur sa face supérieure une pluralité de trous traversants (104) agencés de manière à ce qu'ils coïncident avec des points de connexion (107), situés sur la face arrière de cellules photovoltaïques (102), et sur sa face inférieure un macro circuit imprimé (105) permettant de réaliser les connexions entre les cellules (102),
- arrêt du film souple (103) au niveau d'un masque de soudage, ledit masque étant ajusté contre la face du film comportant le macro circuit imprimé (105) afin que ledit masque recouvre la totalité du film (103) exceptés les trous traversants (104),
- positionnement des cellules photovoltaïques (102) sur la face dudit film (103) opposée à la face comportant ledit circuit imprimé (105), les points de connexion (107) desdites cellules (102) étant ajustés exactement aux emplacements adéquats en regard des trous traversants (104) métallisés du film (103),
- brasure à la vague des cellules photovoltaïques (102) aux points de connexion (107) sur le film (103).

2. Procédé selon la revendication 1, **caractérisé en ce que** l'opération de brasure est réalisée par une opération de brasure à la mini vague sélective.

3. Procédé selon la revendication 2, **caractérisé en ce que** les cellules photovoltaïques (102) sont maintenues sur le film (103) durant l'opération de brasure à la mini vague sélective.

4. Procédé selon l'une des revendications 2 ou 3, **caractérisé par le fait que** l'opération de brasure à la mini vague sélective est effectuée dans un bain de soudure sans plomb.

5. Procédé selon l'une des revendications précédentes, **caractérisé en ce que** le film (103) est obtenu par accouplement d'une couche de Tedlar® d'épaisseur comprise entre 15 et 45 microns, de préférence 25 microns, sur une couche de Mylar® présentant une épaisseur comprise entre 75 et 125 microns, de préférence 100 microns.

6. Procédé selon l'une des revendications précédentes **caractérisé en ce qu'**il comporte une étape de fluxage des trous métallisés traversants (104) du film (103) avant l'opération de brasure à la vague.

7. Procédé selon l'une des revendications précédentes, **caractérisé en ce que** le masque de soudage comporte une table comportant deux parois entre lesquelles on fait circuler un flux d'air.

8. Procédé selon la revendication 6, **caractérisé en ce que** l'opération de brasure est effectuée dans un environnement azoté.

9. Procédé de fabrication d'un module photovoltaïque comprenant un nombre quelconque de cellules photovoltaïques (102) dont les connexions électriques sont réalisées selon le procédé revendiqué à l'une des revendications 1 à 8, **caractérisé en ce qu'**il comporte une étape de laminage de l'ensemble constitué du film souple (103) et des cellules photovoltaïques (102) puis une opération d'encapsulage de cet ensemble entre deux films EVA (112) de propriété chimique-physique adaptée et enfin l'encapsulage du module résultant entre deux couches de verre (113) ou une couche de verre (113) et une couche d'un matériau résistant aux rayons ultra-violets.

## Patentansprüche

1. Verfahren, welches das Herstellen einer elektrischen Kopplung von Fotovoltaik-Zellen (102) untereinander sowie die externe Verbindung der Zellen (102) mit einer Abzweigdose (116) erlaubt, **dadurch gekennzeichnet, dass** es die folgenden Schritte umfasst:
- Befördern eines flexiblen Tragefilms (103) in kontinuierlicher Weise oder mittels eines Überführungsschlittens, wobei der Tragefilm (103) durch Verbinden eines Blatts aus einem Material, welches Widerstandseigenschaften gegen ultraviolette Strahlen aufweist, und eines Blatts aus einem Material, welches elektrisch isolierend und widerstandsfähig gegen erhöhte Temperaturen ist, erhalten wird, wobei der Film an seiner oberen Fläche eine Mehrzahl von Durchgangslöchern (104), welche derart angeordnet sind, dass sie mit Verbindungspunkten (107) zusammenfallen, welche an der hinteren Fläche der Fotovoltaik-Zellen (102) angeordnet sind, sowie an einer unteren Fläche eine gedruckte Makroschaltung (105) aufweist, welche es erlaubt, Verbindungen zwischen den Zellen (102) herzustellen,
- Anhalten des flexiblen Films (103) auf dem Niveau einer Schweißmaske, wobei die Maske gegen die Fläche des Films ausgerichtet ist, welche die gedruckte Makroschaltung (105) umfasst, so dass die Maske den gesamten Film (103) mit Ausnahme der Durchgangslöcher (104) bedeckt,
- Positionieren der Fotovoltaik-Zellen (102) auf der Fläche des Films (103) gegenüber der Fläche, welche die gedruckte Schaltung (105) umfasst, wobei die Verbindungspunkte (107) der Zellen (102) exakt mit den geeigneten Positionen gegenüber den metallisierten Durchgangslöchern (104) des Films (103) ausgerichtet werden,
- Wellenlöten der Fotovoltaik-Zellen (102) an den Verbindungspunkten (107) auf dem Film (103).

2. Verfahren nach Anspruch 1, **dadurch gekennzeichnet, dass** der Lötvorgang durch einen Lötvorgang mit selektiven Kleinwellen gebildet ist.

3. Verfahren nach Anspruch 2, **dadurch gekennzeichnet, dass** die Fotovoltaik-Zellen (102) während des Lötvorgangs mit selektiven Kleinwellen auf dem Film (103) gehalten werden.

4. Verfahren nach einem der Ansprüche 2 oder 3, **dadurch gekennzeichnet, dass** der Lötvorgang mit selektiven Kleinwellen in einem bleifreien Lötbad durchgeführt wird.

5. Verfahren nach einem der vorhergehenden Ansprüche, **dadurch gekennzeichnet, dass** der Film (103) durch Anbringen einer Schicht aus Tedlar® von einer Dicke, welche zwischen 15 und 45 Mikron, vorzugsweise 25 Mikron, beträgt, auf eine Schicht aus Mylar®, welche eine Dicke aufweist, welche zwischen 75 und 125 Mikron, vorzugsweise 100 Mikron, beträgt, erhalten wird.

6. Verfahren nach einem der vorhergehenden Ansprüche, **dadurch gekennzeichnet, dass** es einen Schritt einer Fließmittelbehandlung der metallisierten Durchgangslöcher (104) des Films (103) vor dem Wellenlötvorgang umfasst.

7. Verfahren nach einem der vorhergehenden Ansprüche, **dadurch gekennzeichnet, dass** die Schweißmaske eine Platte umfasst, welche zwei Wände aufweist, zwischen welchen ein Luftstrom zirkuliert wird.

8. Verfahren nach Anspruch 6, **dadurch gekennzeichnet, dass** der Lötvorgang in einer Stickstoff-Umgebung durchgeführt wird.

9. Verfahren zum Herstellen eines Fotovoltaik-Moduls, welches eine beliebige Anzahl von Fotovoltaik-Zellen (102) umfasst, deren elektrische Verbindungen gemäß dem erfindungsgemäßen Verfahren nach einem der Ansprüche 1 bis 8 hergestellt werden, **dadurch gekennzeichnet, dass** es einen Schritt eines Laminierens der Anordnung bestehend aus dem flexiblen Film (103) und den Fotovoltaik-Zellen (102), und dann einen Verkapselungsvorgang dieser Anordnung zwischen zwei EVA-Filmen (112) umfasst, welche geeignete chemisch-physische Eigenschaften aufweisen, und schließlich eine Verkapselung des Moduls zwischen zwei Schichten aus Glas (113) oder einer Schicht aus Glas (113) und einer Schicht aus einem Material, welches widerstandsfähig gegen ultraviolette Strahlung ist.

## Claims

1. A method allowing the electric coupling of photovoltaic cells (102) with one another and the peripheral connection of the cells (102) to a junction box (116), **characterized in that** it comprises the following steps:
- feeding a flexible support film (103) continuously or by means of a conveyor carriage, said support film (103) being obtained by coupling a sheet of material having properties of resistance to ultra-violet rays and a sheet of an electrically insulating material resistant to high temperatures, said film comprising on its upper face a plurality of through-holes (104) arranged so that they coincide with connection points (107) located on the rear face of photovoltaic cells (102), and on its lower face a printed macrocircuit (105) allowing the connections among the cells (102) to be created,
- stopping the flexible film (103) at a solder mask, said mask being fitted against the face of the film comprising the printed macrocircuit (105) in such a way that said mask covers the entirety of the film (103) except the through-holes (104),
- positioning the photovoltaic cells (102) on the face of said film (103) which is opposite the face comprising said printed circuit (105), the connection points (107) of said cells (102) being fitted exactly at the suitable locations with regard to the metallized through-holes (104) of the film (103),
- wave soldering the photovoltaic cells (102) to the connection points (107) on the film (103).

2. A method according to claim 1, **characterized in that** the soldering operation is carried out by a selective mini-wave soldering operation.

3. A method according to claim 2, **characterized in that** the photovoltaic cells (102) are held on the film (103) during the selective mini-wave soldering operation.

4. A method according to one of claims 2 and 3, **characterized in that** the selective mini-wave soldering operation is carried out in a lead-free solder bath.

5. A method according to one of the preceding claims, **characterized in that** the film (103) is obtained by coupling a layer of Tedlar® having a thickness of between 15 and 45 microns, preferably 25 microns, to a layer of Mylar® having a thickness of between 75 and 125 microns, preferably 100 microns.

6. A method according to one of the preceding claims, **characterized in that** it comprises a step of fluxing the metallized through-holes (104) of the film (103) before the wave soldering operation.

7. A method according to one of the preceding claims, **characterized in that** the solder mask consists of a table comprising two walls between which an air flow is circulated.

8. A method according to claim 6, **characterized in that** the soldering operation is carried out in a nitrogen environment.

9. A method for manufacturing a photovoltaic module comprising any number of photovoltaic cells (102), the electrical connections of which are created according to the method claimed in one of claims 1 to 8, **characterized in that** it comprises a step of laminating the assembly consisting of the flexible film (103) and the photovoltaic cells (102), then an encapsulation operation of this assembly between two EVA films (112) having suitable chemical and physical properties and finally the encapsulation of the resulting module between two layers of glass (113) or a layer of glass (113) and a layer of a material resistant to ultra-violet rays.
